# EUROPEAN PATENT APPLICATION

(11) **EP 4 697 907 A1**
(43) Date of publication of application: **18.02.2026**
(21) Application number: 23939066.9
(22) Date of filing: 28.06.2023
(51) Int. Cl.: H10K 30/50

(54) **PEROVSKITE SOLAR CELL AND PREPARATION METHOD THEREFOR, AND PHOTOVOLTAIC MODULE**

(30) Priority: 30.05.2023 CN 202310621856
(71) Applicant: Shenzhen Hanke New Material Technology Co., Ltd., Shenzhen, Guangdong 518000 (CN)
(72) Inventor: WANG, Rongfu, Shenzhen, Guangdong 518000 (CN); YI, Dian, Shenzhen, Guangdong 518000 (CN)
(74) Representative: Greaves Brewster LLP
(86) International application number: PCT/CN2023/103101
(87) International publication number: WO 2024/244083

(57) **Abstract**

The present disclosure provides a perovskite solar cell and a preparation method therefor, and a photovoltaic module. The perovskite solar cell comprises a substrate, a first charge extraction layer (120), a perovskite layer (130), a composite protective layer (140), and a second charge extraction layer (150), wherein the composite protective layer (140) comprises a boron nitride layer (141) and a graphene material layer (142) which are sequentially stacked on the perovskite layer (130).

## Description

This application claims priority of China Patent Application No. 202310621856X, filed on May 30, 2023, entitled "PEROVSKITE SOLAR CELL AND PREPARATION METHOD THEREFOR, AND PHOTOVOLTAIC MODULE", the content of which is hereby incorporated by reference in its entirety.

### TECHNICAL FIELD

The present application relates to the technical field of solar cells, particularly relates to a perovskite solar cell and a preparation method therefor, and a photovoltaic module.

### BACKGROUND

Perovskite solar cells are a type of solar cells with a compound having a perovskite structure as a light-absorbing layer. Compared to conventional crystalline silicon solar cells, the perovskite solar cells have advantages such as a broader absorption range and a higher absorption coefficient. Laboratory efficiencies of the perovskite solar cells have been gradually increased from an initial 3.8% to over 25.7% today. Furthermore, the perovskite solar cell can be combined with the crystalline silicon solar cell to form a tandem structure to broaden the overall absorption spectrum range of the solar cells. Despite the aforementioned advantages of the perovskite solar cells, the long-term stability of the perovskite solar cells remains a significant challenge for their further development. Additionally, the inferior stability of perovskite materials also limits the preparation methods for other functional layers of the solar cells.

### SUMMARY

According to some embodiments of the present application, a perovskite solar cell is provided, which includes a substrate, a first charge extraction layer, a perovskite layer, a composite protective layer, and a second charge extraction layer. The first charge extraction layer, the perovskite layer, the composite protective layer, and the second charge extraction layer are sequentially stacked on the substrate. The composite protective layer includes a boron nitride layer and a graphene material layer sequentially stacked on the perovskite layer.

In some embodiments of the present application, a thickness of the boron nitride layer is ≤10 nm.

In some embodiments of the present application, a thickness of the graphene material layer is ≤10 nm.

In some embodiments of the present application, the boron nitride layer is in direct contact with the perovskite layer, and the graphene material layer is in direct contact with the boron nitride layer.

In some embodiments of the present application, the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

In some embodiments of the present application, the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.

Further, the present application provides a method for preparing a perovskite solar cell, including the following steps:
providing a substrate;
preparing a first charge extraction layer on the substrate;
preparing a perovskite layer on the first charge extraction layer;
sequentially preparing a boron nitride layer and a graphene material layer on the perovskite layer to form a composite protective layer; and
preparing a second charge extraction layer on the graphene material layer.

In some embodiments of the present application, a thickness of the boron nitride layer is ≤10 nm.

In some embodiments of the present application, a thickness of the graphene material layer is ≤10 nm.

In some embodiments of the present application, the boron nitride layer is in direct contact with the perovskite layer, and the graphene material layer is in direct contact with the boron nitride layer.

In some embodiments of the present application, the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

In some embodiments of the present application, the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.

In some embodiments of the present application, the boron nitride layer is prepared by sputtering, and the graphene material layer is prepared by sputtering.

In some embodiments of the present application, in the step of preparing the boron nitride layer, hexagonal boron nitride is used as a sputtering target, a sputtering power is controlled in a range from 200 W to 350 W, and a sputtering time period is controlled in a range from 1 minutes (min) to 10 min.

In some embodiments of the present application, in the step of preparing the graphene material layer, graphite is used as a sputtering target, a sputtering power is controlled in a range from 300 W to 400 W, and a sputtering time period is controlled in a range from 1 min to 10 min.

In some embodiments of the present application, the first charge extraction layer, the perovskite layer, the boron nitride layer, the graphene material layer, and the second charge extraction layer are sequentially prepared by sputtering in a sputtering chamber.

In some embodiments of the present application, the substrate includes a base material and a first electrode disposed on the base material. Before preparing the first charge extraction layer, the method further includes a step of subjecting the base material to plasma cleaning.

In some embodiments of the present application, after preparing the second charge extraction layer, the method further includes a step of preparing a second electrode on the second charge extraction layer. The second electrode is prepared by sputtering.

According to some embodiments of the present application, a photovoltaic module is further provided, which includes an encapsulation structure and a perovskite solar cell encapsulated by the encapsulation structure. The perovskite solar cell includes a substrate, a first charge extraction layer, a perovskite layer, a composite protective layer, and a second charge extraction layer. The first charge extraction layer, the perovskite layer, the composite protective layer, and the second charge extraction layer are sequentially stacked on the substrate. The composite protective layer includes a boron nitride layer and a graphene material layer sequentially stacked on the perovskite layer.

In some embodiments of the present application, a thickness of the boron nitride layer is ≤10 nm.

In some embodiments of the present application, a thickness of the graphene material layer is ≤10 nm.

In some embodiments of the present application, the boron nitride layer is in direct contact with the perovskite layer, and the graphene material layer is in direct contact with the boron nitride layer.

In some embodiments of the present application, the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

In some embodiments of the present application, the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.

Details of one or more embodiments of the present application are presented in the accompanying drawings and descriptions below. Further features, objectives, and advantages of the present application will become apparent from the description, drawings, and claims.

### BRIEF DESCRIPTION OF THE DRAWINGS

To describe the technical solutions in the embodiments of the present application more clearly, the accompanying drawings for describing the embodiments are briefly introduced below. It is evident that the following described drawings are merely for some embodiments of the present application, and other drawings can be derived by those of ordinary skill in the art without any creative effort.
FIG. 1 is a schematic view of a perovskite solar cell.
FIG. 2 is a schematic view illustrating steps of a method for preparing the perovskite solar cell in FIG. 1.
FIG. 3 is a schematic view of a substrate.
FIG. 4 is a schematic structural view of a first charge extraction layer prepared on the structure shown in FIG. 3.
FIG. 5 is a schematic structural view of a perovskite layer prepared on the structure shown in FIG. 4.
FIG. 6 is a schematic structural view of a boron nitride layer and a graphene material layer that are prepared on the structure shown in FIG. 5.
FIG. 7 is a schematic structural view of a second charge extraction layer prepared on the structure shown in FIG. 6.

### Reference numerals and meanings thereof:

100, base material; 110, first electrode; 120, first charge extraction layer; 130, perovskite layer; 140, composite protective layer; 141, boron nitride layer; 142, graphene material layer; 150, second charge extraction layer; 160, second electrode.

### DETAILED DESCRIPTION

In order to facilitate an understanding of the present application, the present application will now be described more comprehensively hereinafter with reference to the related accompanying drawings. Preferred embodiments of the present application are shown in the drawings. The present application may, however, be implemented in many different forms and is not limited to the embodiments described herein. On the contrary, the purpose of providing these embodiments is to provide a more thorough and comprehensive understanding of the disclosed content of the present application.

Unless defined otherwise, all technical and scientific terms used herein have the same meaning as commonly understood by one of ordinary skill in the art to which the present application pertains. The terminology used herein in the description of the present application is for the purpose of describing specific embodiments only and is not intended to limit the present application. The term "and/or" used herein includes any and all combinations of one or more related listed items.

It should be understood that, an element or layer, when being referred to as being "on", "adjacent to", "connected to", or "coupled to" another element or layer, may be directly on, adjacent to, connected to, or coupled to another element or layer, or an intermediate element or layer may be present. Electrical connection means that electrical current can be conducted between multiple elements that are electrically connected, which specifically may be achieved either by direct contact between one element and another element, or by connecting one element to another element through an additional conductive element. In contrast, when an element is referred to as being "directly on", "directly adjacent to", "directly connected to", or "directly coupled to" another element or layer, no intermediate element or layer is present. It should be understood that, although the terms such as first, second, third, etc. can be used to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section described below can be termed as a second element, component, region, layer, or section without departing from the teachings of the present application.

The spatial relation terms such as "below", "under", "beneath", "underneath" "above", "on", etc., may be used herein to conveniently describe the relationships of an element or a feature with other elements or features shown in the drawings. It should be understood that besides the orientations of the elements or features shown in the drawings, the spatial relation terms are intended to cover other different orientations in use or operation. For example, if the device shown in the drawings are placed upside down, an element or feature which was described as "below", "under", or "beneath" other elements or features will be "above" the other elements or features. Thus, the exemplary terms "below", and "under" can cover the orientations of above and below. The device can also be positioned in other different orientations (e.g., rotating 90 degrees or at other orientations), and the spatial relation terms used herein can be correspondingly interpreted.

The terminology used herein is for the purpose of describing specific embodiments only and is not intended to limit the present application. As used herein, the singular form with "a", "an", or "the/said" are intended to cover the plural form as well, unless the context clearly indicates otherwise. It should also be understood that the terms "be composed of" and/or "include", when used in the specification, identify the presence of the stated features, integers, steps, operations, elements and/or parts, but do not exclude presence or addition of one or more of other features, integers, steps, operations, elements, parts and/or groups. As used herein, the term "and/or" includes any and all combinations of one or more related listed items.

The present application provides a perovskite solar cell, which includes a substrate, a first charge extraction layer, a perovskite layer, a composite protective layer, and a second charge extraction layer. The first charge extraction layer, the perovskite layer, the composite protective layer, and the second charge extraction layer are sequentially stacked on the substrate. The composite protective layer includes a boron nitride layer and a graphene material layer sequentially stacked on the perovskite layer.

The boron nitride layer includes can include hexagonal boron nitride, and the graphene material layer includes graphene. The crystal lattice structures of hexagonal boron nitride and graphene are relatively similar, both being of a hexagonal planar structure. Therefore, there is good crystal lattice matching between graphene and hexagonal boron nitride. Even with very few layers, graphene and hexagonal boron nitride can exhibit strong barrier properties against permeation. Therefore, graphene and hexagonal boron nitride can effectively inhibit the contact between the perovskite material and other external materials.

In at least one of the embodiments of the present application, the perovskite solar cell includes the first charge extraction layer, the perovskite layer, the composite protective layer, and the second charge extraction layer that are sequentially stacked. The composite protective layer includes the boron nitride layer and the graphene material layer that are sequentially stacked. The crystal lattice matching between the boron nitride layer and the graphene material layer is relatively high, allowing the boron nitride layer to serve as a substrate for the preparation of the graphene material layer, so that the composite protective layer can be stably disposed on the perovskite layer. Furthermore, the composite protective layer can exhibit high mechanical strength and chemical stability while remaining transparent, which prevents external impurities from affecting the perovskite layer and enhances the long-term stability of the perovskite solar cell on one hand. On the other hand, the composite protective layer can further protect the perovskite layer during the preparation of the second charge extraction layer and other functional layers located on the perovskite layer, thereby broadening the practical preparation processes for the second charge extraction layer and other functional layers, allowing the second charge extraction layer and other functional layers to be prepared using relatively simple processes.

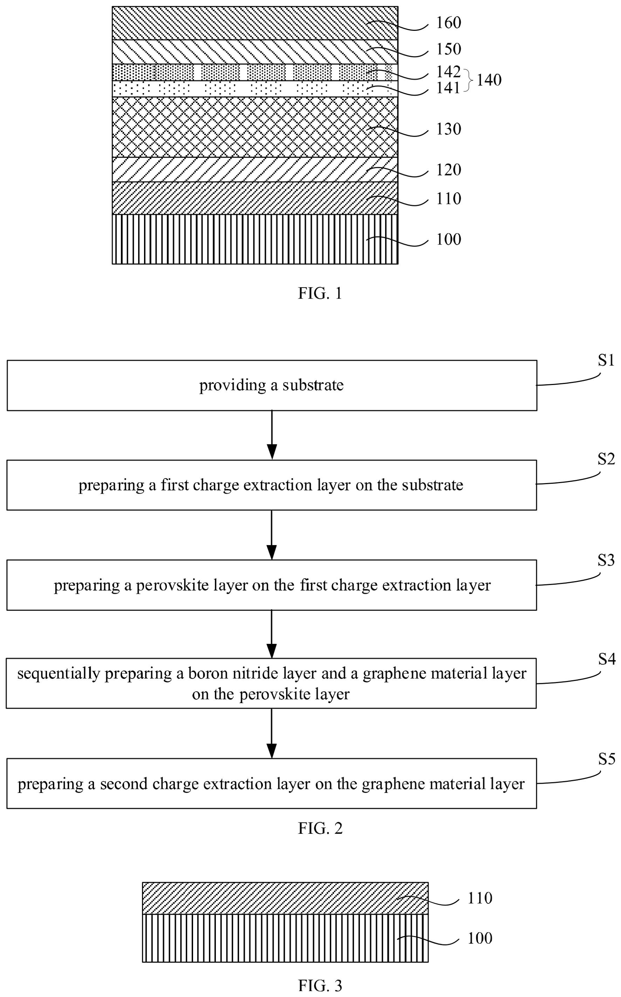

FIG. 1 shows a schematic view of a perovskite solar cell to facilitate an understanding of a specific structure of the perovskite solar cell provided in the present application.

Referring to FIG. 1, the perovskite solar cell includes a substrate, a first charge extraction layer 120, a perovskite layer 130, a composite protective layer 140, and a second charge extraction layer 150. The first charge extraction layer 120, the perovskite layer 130, the composite protective layer 140, and the second charge extraction layer 150 are sequentially stacked on the substrate. The composite protective layer 140 includes a boron nitride layer 141 and a graphene material layer 142 sequentially stacked on the perovskite layer 130.

Further, in some examples of the embodiment, the substrate of the perovskite solar cell includes a base material 100 and a first electrode 110. The perovskite solar cell further includes a second electrode 160.

The base material 100 is configured to support the various functional layers. In some examples of the embodiment, the base material 100 can be a transparent material. For example, the base material 100 can be selected from glass or a transparent polymer material. The transparent polymer material can be polyethylene terephthalate (PET) or polyimide (PI). In an embodiment, the base material 100 is polyethylene terephthalate.

In some examples of the embodiment, a material of the first electrode 110 can include a transparent conductive metal oxide. For example, the transparent conductive oxide can be one or more selected from the group consisting of indium tin oxide, indium gallium zinc oxide, aluminum zinc oxide, and fluorine-doped tin oxide. In an embodiment, the transparent conductive oxide can be indium tin oxide.

In some examples of the embodiment, the first charge extraction layer 120 can be an electron transport layer. Further, a material of the first charge extraction layer 120 can be one or more selected from the group consisting of fullerene, tin oxide, tungsten sulfide, zinc oxide, titanium oxide, tungsten oxide, and indium gallium zinc oxide. The electron transport layer is configured to conduct carriers generated by the perovskite layer 130 to an outer electrode, thereby forming a usable electric current.

In some examples of the embodiment, a thickness of the first charge extraction layer 120 can be in a range from 10 nm to 100 nm. Further, the thickness of the first charge extraction layer 120 can be 10 nm, 20 nm, 30 nm, 50 nm, 80 nm, or 100 nm, or the thickness of the first charge extraction layer 120 can be within a range between any two of the aforementioned thicknesses.

The perovskite layer 130 is configured to absorb light and produce photogenerated carriers. The perovskite layer 130 refers to a semiconductor material with a perovskite crystal lattice structure. In some examples of the embodiment, the material of the perovskite layer 130 can include a compound with a general formula of ABX₃, wherein A can be one or more selected from the group consisting of a cesium ion, a formamidinium ion (FA), and a methylammonium ion (MA), B can be selected from a lead ion, and X can be selected from a halide ion. In an embodiment, the material of the perovskite layer 130 can be methylammonium lead iodide (MAPbI₃).

In some examples of the embodiment, a thickness of the perovskite layer 130 can be in a range from 100 nm to 1000 nm. Further, the thickness of the perovskite layer 130 can be 100 nm, 200 nm, 300 nm, 500 nm, 800 nm, or 1000 nm, or the thickness of the perovskite layer 130 can be within a range between any two of the aforementioned thicknesses.

In some examples of the embodiment, the boron nitride layer 141 is in direct contact with the perovskite layer 130. Further, the boron nitride layer 141 covers a surface of the perovskite layer 130 facing away from the first charge extraction layer 120. The boron nitride layer 141 can include hexagonal boron nitride that has a layered structure.

In some examples of the embodiment, a thickness of the boron nitride layer 141 is ≤10 nm. For example, the thickness of the boron nitride layer 141 can be in a range from 1 nm to 10 nm. Further, the thickness of the boron nitride layer 141 can be 1 nm, 2 nm, 3 nm, 5 nm, 8 nm, or 10 nm, or the thickness of the boron nitride layer 141 can be within a range between any two of the aforementioned thicknesses. Setting the thickness of the boron nitride layer 141 to be relatively thin facilitates carrier tunneling through the boron nitride layer 141, thereby reducing the carrier loss as much as possible.

In some examples of the embodiment, the graphene material layer 142 is in direct contact with the boron nitride layer 141. Further, the graphene material layer 142 covers a surface of the boron nitride layer 141 facing away from the perovskite layer 130.

In some examples of the embodiment, a thickness of the graphene material layer 142 is ≤10 nm. For example, the thickness of the graphene material layer 142 can be in a range from 1 nm to 10 nm. Further, the thickness of the graphene material layer 142 can be 1 nm, 2 nm, 3 nm, 5 nm, 8 nm, or 10 nm, or the thickness of the graphene material layer 142 can be within a range between any two of the aforementioned thicknesses.

By using a stacked configuration of the boron nitride layer 141 and the graphene material layer 142 as the composite protective layer 140, with the boron nitride layer 141 directly positioned on the surface of the perovskite layer 130, a passivation effect on the perovskite layer 130 can be achieved. Additionally, since the boron nitride layer 141 has a crystal lattice that is relatively matched with graphene, using it as a substrate for adhering the graphene material layer 142 can ensure that the composite protective layer 140 as a whole is relatively stable and resistant to delamination. The composite protective layer 140 provides effective protection for the perovskite layer 130, ensuring the long-term stability of the perovskite layer 130 with substantially no impact on carrier conductivity.

In conventional art, the perovskite layer 130 is typically in direct contact with the charge extraction layer to ensure a relatively high carrier transport efficiency between the perovskite layer 130 and the charge extraction layer. In the perovskite solar cell provided in the present application, the composite protective layer 140 is further interposed between the perovskite layer 130 and the second charge extraction layer 150. This composite protective layer 140 can ensure the long-term stability of the perovskite layer 130 with substantially no impact on carrier conductivity. Further, this composite protective layer 140 exhibits strong blocking ability against high-velocity particles generated during subsequent sputtering process, enabling the second charge extraction layer 150 to be prepared via a sputtering method.

In some examples of the embodiment, the second charge extraction layer 150 can be a hole transport layer. Further, a material of the second charge extraction layer 150 can be one or more selected from the group consisting of nickel oxide, copper oxide, copper sulfide, molybdenum sulfide, vanadium oxide, tungsten oxide, and copper thiocyanate. The hole transport layer is configured to conduct holes generated by the perovskite layer 130 to an outer electrode, thereby forming a usable electric current.

In some examples of the embodiment, a thickness of the second charge extraction layer 150 can be in a range from 10 nm to 100 nm. Further, the thickness of the second charge extraction layer 150 can be 10 nm, 20 nm, 30 nm, 50 nm, 80 nm, or 100 nm, or the thickness of the second charge extraction layer 150 can be within a range between any two of the aforementioned thicknesses.

In some examples of the embodiment, a material of the second electrode 160 can be a metallic material. For example, the material of the second electrode 160 can be one or more selected from the group consisting of copper, silver, aluminum, gold, and molybdenum.

In some examples of the embodiment, a thickness of the second electrode 160 can be in a range from 50 nm to 500 nm. Further, the thickness of the second electrode 160 can be 50 nm, 100 nm, 200 nm, 300 nm, 400 nm, or 500 nm, or the thickness of the second electrode 160 can be within a range between any two of the aforementioned thicknesses.

It should be understood that in the perovskite solar cell in the embodiment, the layers sequentially stacked on the substrate can be prepared in the order of their stacking sequence. In the embodiment, the hole transport layer is positioned above the perovskite layer 130. However, in other embodiments, the hole transport layer may be positioned under the perovskite layer 130, while the electron transport layer may be positioned above the perovskite layer 130. This also falls within the scope of the perovskite solar cell provided in the present application.

FIG. 2 is a schematic view illustrating steps of a preparation method for the perovskite solar cell shown in FIG. 1. Referring to FIG. 2, the preparation method for the perovskite solar cell includes steps S1 to S5.

Step S1: providing a substrate.

FIG. 3 is a schematic structural view of the substrate.

In some examples of the embodiment, referring to FIG. 3, in some examples of the embodiment, the substrate includes a base material 100 and a first electrode 110 disposed on the base material 100.

In some examples of the embodiment, the step of providing the substrate includes: providing the base material 100, and preparing the first electrode 110 on the base material 100.

In an embodiment, the base material 100 can be selected from glass or a transparent polymer material. In an embodiment, the base material 100 is polyethylene terephthalate.

In some examples of the embodiment, a length of the base material 100 can be in a range from 1 m to 10,000 m. It should be understood that for the base material 100 which is relatively long, a method of gradually moving the base material 100 can be used to progressively prepare individual material layers on the surface of the base material 100. This is a continuous production method, which can effectively enhance the preparation efficiency of the perovskite solar cell.

In some examples of the embodiment, a material of the first electrode 110 can include a transparent conductive metal oxide. In an embodiment, the transparent conductive oxide can be indium tin oxide.

In some examples of the embodiment, the step of preparing the first electrode 110 on the base material 100 can include: placing the base material 100 in a magnetron sputtering chamber, subjecting the base material 100 to a plasma cleaning treatment, and then sputter-depositing the material for the first electrode 110 onto the surface of the base material 100. During the plasma cleaning treatment, a gas used is a protective gas. For example, a mixed gas of argon gas and nitrogen gas can be used for the plasma cleaning treatment of the base material 100.

In some examples of the embodiment, after sputter-depositing the first electrode 110 onto the surface of the base material 100, the first electrode 110 can be subjected to a first laser scribing treatment to form a patterned first electrode 110. The purpose of forming the patterned first electrode 110 is to ultimately enable the preparation of a plurality of perovskite solar cells.

Step S2: preparing a first charge extraction layer 120 on the substrate.

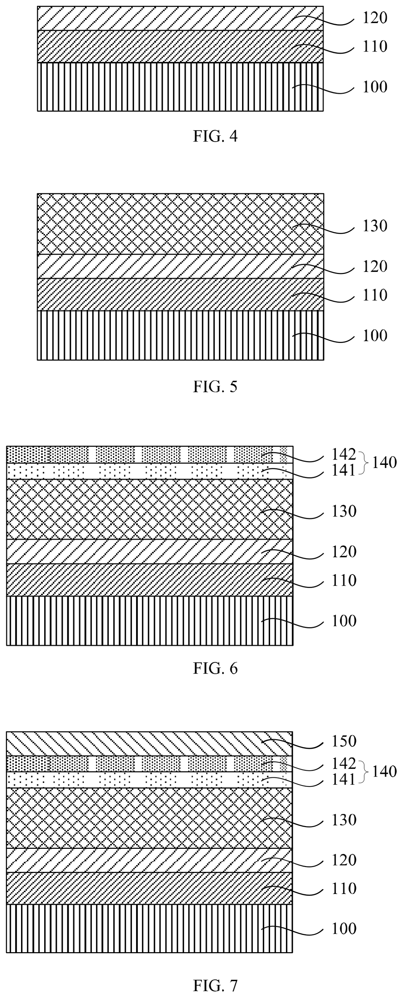

FIG. 4 is a schematic structural view of the first charge extraction layer 120 prepared on the structure shown in FIG. 3.

In some examples of the embodiment, the first charge extraction layer 120 can be an electron transport layer. Further, a material of the first charge extraction layer 120 can be one or more selected from the group consisting of fullerene, tin oxide, tungsten sulfide, zinc oxide, titanium oxide, tungsten oxide, and indium gallium zinc oxide. In an embodiment, the material of the first charge extraction layer 120 is tin oxide.

In some examples of the embodiment, a method for preparing the first charge extraction layer 120 can be sputtering. For example, tin oxide can be used as a target to prepare the first charge extraction layer 120 on the first electrode 110. Further, the method for preparing the first charge extraction layer 120 can be magnetron sputtering.

In some examples of the embodiment, a thickness of the first charge extraction layer 120 can be controlled in a range from 10 nm to 100 nm.

Magnetron sputtering is a method capable of achieving large-area and large-scale preparation, offering advantages of simple process and high preparation efficiency. To further enhance efficiency, the sputtering chamber for preparing the first charge extraction layer 120 can be the same as the sputtering chamber for preparing the first electrode 110, or the sputtering chamber for preparing the first charge extraction layer 120 can be connected to the sputtering chamber for preparing the first electrode 110. It should be understood that when the sputtering chambers are the same sputtering chamber, multiple sputtering targets can be simultaneously provided within the sputtering chamber, so that the first charge extraction layer 120 and the first electrode 110 can be each prepared.

Step S3: preparing a perovskite layer 130 on the first charge extraction layer 120.

FIG. 5 is a schematic structural view of the perovskite layer 130 prepared on the structure shown in FIG. 4.

In some examples of the embodiment, a material of the perovskite layer 130 can include a compound having a general formula of ABX₃, wherein A can be one or more selected from the group consisting of a cesium ion, a formamidinium ion (FA), and a methylammonium ion (MA), B can be selected from a lead ion, and X can be selected from a halide ion. In an embodiment, the material of the perovskite layer 130 can be methylammonium lead iodide (MAPbI₃).

In some examples of the embodiment, a method for preparing the perovskite layer 130 can be sputtering. For example, the perovskite layer 130 can be prepared through magnetron sputtering.

When preparing the perovskite layer 130 through the sputtering method, a perovskite material can be used as a target. For example, methylammonium lead iodide can be used as a perovskite target. It should be understood that methylammonium lead iodide is prone to deterioration in air. Therefore, the perovskite target can be placed into the sputtering chamber immediately upon preparation to ensure its quality.

In some examples of the embodiment, a thickness of the perovskite layer 130 can be controlled in a range from 100 nm to 1000 nm.

To further enhance efficiency, the sputtering chamber for preparing the perovskite layer 130 can be the same as the sputtering chamber for preparing the first charge extraction layer 120, or the sputtering chamber for preparing the perovskite layer 130 can be connected to the sputtering chamber for preparing the first charge extraction layer 120.

Step S4: sequentially preparing a boron nitride layer 141 and a graphene material layer 142 onto the perovskite layer 130.

FIG. 6 is a schematic structural view of the boron nitride layer 141 and the graphene material layer 142 that are prepared on the structure shown in FIG. 5.

Referring to FIG. 6, the boron nitride layer 141 and the graphene material layer 142 form a composite protective layer 140 disposed on the perovskite layer 130.

In some examples of the embodiment, the boron nitride layer 141 is in contact with the perovskite layer 130, and the graphene material layer 142 is in contact with the boron nitride layer 141.

In some examples of the embodiment, the boron nitride layer 141 is prepared by magnetron sputtering, and the graphene material layer 142 is prepared by magnetron sputtering.

In some examples of the embodiment, in the step of preparing the boron nitride layer 141, hexagonal boron nitride is used as a sputtering target.

In some examples of the embodiment, in the step of preparing the boron nitride layer 141, a magnetron sputtering power can be controlled in a range from 200 W to 350 W. A relatively low sputtering power can be used during preparing the boron nitride layer 141, which can reduce damage to the perovskite layer 130 as much as possible during preparing the boron nitride layer 141. In this case, the boron nitride layer 141 primarily serves as a growth substrate for the graphene material layer 142 subsequently prepared, and enables stable bonding of the graphene material layer 142 to the perovskite layer 130, thereby providing a good barrier property.

In some examples of the embodiment, in the step of preparing the boron nitride layer 141, a sputtering time period can be controlled in a range from 1 min to 10 min. By controlling the sputtering time period, the thickness of the boron nitride layer 141 can be controlled to reduce the impact on carrier conduction as much as possible due to introduction of the boron nitride layer 141.

In some examples of the embodiment, in the step of preparing the graphene material layer 142, graphite can be used as a sputtering target.

In some examples of the embodiment, in the step of preparing the graphene material layer 142, a magnetron sputtering power can be controlled in a range from 300 W to 400 W. For example, the sputtering power can be controlled to be 300 W, 320 W, 350 W, 380 W, or 400 W, or the sputtering power can be controlled within a range between any two of the aforementioned power values. The boron nitride layer 141 can serve as the growth substrate for the graphene material layer 142. Since hexagonal boron nitride has a crystal lattice similar to that of graphene, the graphene material layer 142 can be spontaneously formed on the hexagonal boron nitride by using the graphene target in the process of magnetron sputtering. Furthermore, the boron nitride layer 141 prepared previously can also block particles during the sputtering process. This enables the formation of a relatively dense graphene material layer 142 while reducing the impact of the sputtering process on the perovskite layer 130.

In some examples of the embodiment, in the step of preparing the graphene material layer 142, a sputtering time period is controlled in a range from 1 min to 10 min. By controlling the sputtering time period, the thickness of the graphene material layer 142 can be controlled to reduce the impact on carrier conduction as much as possible due to introduction of the graphene material layer 142.

In some examples of the embodiment, the sputtering chambers for preparing the boron nitride layer 141 and the graphene material layer 142 can be the same as the sputtering chamber for preparing the perovskite layer 130, or the sputtering chambers for preparing the boron nitride layer 141 and the graphene material layer 142 can be connected to the sputtering chamber for preparing the perovskite layer 130, which can enhance the preparation efficiency of the boron nitride layer 141 and the graphene material layer 142.

Step S5: preparing a second charge extraction layer 150 on the graphene material layer 142.

FIG. 7 is a schematic structural view of the second charge extraction layer 150 prepared on the structure shown in FIG. 6.

Referring to FIG. 7, the second charge extraction layer 150 is disposed on the graphene material layer 142.

In some examples of the embodiment, the second charge extraction layer 150 can be a hole transport layer. Furthermore, a material of the second charge extraction layer 150 can be one or more selected from the group consisting of nickel oxide (NiOₓ), copper oxide (CuOₓ), copper sulfide, molybdenum sulfide, vanadium oxide (VO_{X}), tungsten oxide, and copper thiocyanate. With an inorganic material as the hole transport layer, the hole transport layer can also be prepared by sputtering.

In some examples of the embodiment, a method for preparing the second charge extraction layer 150 can also be sputtering. For example, nickel oxide can be used as a target to prepare the second charge extraction layer 150 on the graphene material layer 142. Further, a method for preparing the second charge extraction layer 150 can be magnetron sputtering.

In conventional art, an organic material is typically used as the hole transport layer, and the hole transport layer is prepared by coating rather than sputtering. Although sputtering offers a higher production efficiency, the high-energy particles generated in the sputtering process directly bombard the already-prepared perovskite layer 130, which may significantly damage the surface of the perovskite layer 130, leading to a significant degradation in the performance of the perovskite solar cell.

In the embodiment, since the graphene material layer 142 has been prepared previously, the graphene material layer 142 blocks the bombardment from the material of the second charge extraction layer 150 during preparing the second charge extraction layer 150 by sputtering. This enables the preparation of the second charge extraction layer 150 via sputtering while reducing or avoiding damage to the perovskite layer 130.

In some examples of the embodiment, a thickness of the second charge extraction layer 150 can be in a range from 10 nm to 100 nm.

In some examples of the embodiment, the sputtering chamber for preparing the second charge extraction layer 150 can be the same as the sputtering chamber for preparing the graphene material layer 142, or the sputtering chamber for preparing the second charge extraction layer 150 can be connected to the sputtering chamber for preparing the graphene material layer 142, which can enhance the preparation efficiency of the second charge extraction layer 150.

In some examples of the embodiment, after preparing the second charge extraction layer 150, the prepared second charge extraction layer 150, perovskite layer 130, and first charge extraction layer 120 can further be subjected to a second laser scribing treatment. It should be understood that the position of the second laser scribing treatment can be slightly misaligned with that of the first laser scribing treatment to facilitate series connection between the plurality of perovskite solar cells that are ultimately prepared.

In some examples of the embodiment, after preparing the second charge extraction layer 150, a step of preparing a second electrode 160 can be further included.

In some examples of the embodiment, a material of the second electrode 160 can be a metallic material. For example, the material of the second electrode 160 can be one or more selected from the group consisting of copper, silver, aluminum, gold, and molybdenum.

In some examples of the embodiment, a thickness of the second electrode 160 can be in a range from 50 nm to 500 nm.

When sputtering the metal target, a relatively high sputtering power is typically required, which may also affect the perovskite layer 130. Therefore, in conventional art, evaporation rather than sputtering is typically used to prepare the electrode.

In some examples of the embodiment, a method for preparing the second electrode 160 can also be sputtering, such as magnetron sputtering. It should be understood that the graphene material layer 142 is pre-prepared in this preparation method. By forming the graphene material layer 142 which is relatively dense and planar, the energy of metal particles during sputtering can be reduced, thereby reducing or avoiding the damage to the perovskite layer 130.

In some examples of the embodiment, the sputtering chamber for preparing the second electrode 160 can be the same as the sputtering chamber for preparing the second charge extraction layer 150, or the sputtering chamber for preparing the second electrode 160 can be connected to the sputtering chamber for preparing the second charge extraction layer 150, which can enhance the preparation efficiency of the second electrode 160.

It should be understood that in the embodiment, the first charge extraction layer 120, the perovskite layer 130, the boron nitride layer 141, the graphene material layer 142, and the second charge extraction layer 150 are sequentially prepared in the magnetron sputtering chamber(s) via magnetron sputtering. Thus, most film layers in the perovskite solar cell of the present application can be prepared using a continuous sputtering method. Sputtering is a low-cost, large-area preparation method, and preparing various layers through continuous sputtering can further enhance the production efficiency of the perovskite solar cell. Additionally, the boron nitride layer 141 and the graphene material layer 142 prepared by sputtering can reduce the negative impact of sputtering on the efficiency of the perovskite solar cell while improving its production efficiency.

It should be understood that the perovskite solar cell as shown in FIG. 1 can be prepared by the preparation method including steps S1 to S5.

It should be understood that in the preparation method for the perovskite solar cell in the embodiment, the electron transport layer is first prepared, and then the hole transport layer is prepared on the perovskite layer. However, in other embodiments, the hole transport layer can be prepared first, and then the electron transport layer can be prepared on the perovskite layer. This also falls within the scope of the perovskite solar cell provided in the present application.

Additionally, in the conventional art, the perovskite layer and the charge extraction layers are typically prepared by a coating method, and the electrode is typically prepared by an evaporation method. These methods require multiple solvents and additional drying and annealing treatments as well as transfer operations, thereby leading to a significantly higher manufacturing cost, a higher energy consumption, and a significantly longer production time. The preparation method described in the above embodiment employs sputtering to sequentially prepare the perovskite layer, the composite protective layer, the second charge extraction layer, and the second electrode, enabling a sequential preparation on a single sputtering production line, without requiring drying or annealing treatments, which offers advantages of a lower cost, a lower energy consumption, and a shorter production time, making it a highly desirable solar cell manufacturing approach.

Further, the present application provides a photovoltaic module. The photovoltaic module includes an encapsulation structure and a perovskite solar cell encapsulated by the encapsulation structure. The perovskite solar cell is the perovskite solar cell provided in the above embodiments or the perovskite solar cell prepared by the preparation method for the perovskite solar cell provided in the above embodiments.

To facilitate an understanding of the embodiments and advantages of the perovskite solar cell and the preparation method therefor provided in the present application, the following examples and comparative examples are provided in the present application.

### Example 1

A ethylene terephthalate film was provided as a base material. The base material was placed in a magnetron sputtering chamber with argon gas and nitrogen gas introduced, and subjected to plasma cleaning for 30 min.

Indium tin oxide was sputtered on a surface of the base material as a first electrode.

Tin oxide (SnO₂) with a thickness of 20 nm was sputtered and deposited on the first electrode as an electron transport layer.

Methylammonium lead iodide with a thickness of 300 nm was sputtered on the electron transport layer as a perovskite layer.

Hexagonal boron nitride with a thickness of 2 nm was sputtered on the perovskite layer as a boron nitride layer, with boron nitride as a target, a sputtering power controlled to be 250 W, and a sputtering time of 3 min.

Graphene with a thickness of 5 nm was sputtered on the boron nitride layer as a graphene material layer, with graphite as a target, a sputtering power controlled to be 350 W, and a sputtering time of 5 min.

Molybdenum disulfide (MoS₂) with a thickness of 20 nm was sputtered and deposited on the graphene material layer as a hole transport layer.

Sliver with a thickness of 200 nm was sputtered and deposited on the hole transport layer as a second electrode.

### Example 2

A ethylene terephthalate film was provided as a base material. The base material was placed in a magnetron sputtering chamber with argon gas and nitrogen gas introduced, and subjected to plasma cleaning for 30 min.

Indium tin oxide was sputtered on a surface of the base material as a first electrode.

Tin oxide (SnO₂) with a thickness of 20 nm was sputtered and deposited on the first electrode as an electron transport layer.

Methylammonium lead iodide with a thickness of 300 nm was sputtered on the electron transport layer as a perovskite layer.

Hexagonal boron nitride with a thickness of 5 nm was sputtered on the perovskite layer as a boron nitride layer, with boron nitride as a target, a sputtering power controlled to be 250 W, and a sputtering time of 3 min.

Graphene with a thickness of 8 nm was sputtered on the boron nitride layer as a graphene material layer, with graphite as a target, a sputtering power controlled to be 350 W, and a sputtering time of 5 min.

Molybdenum disulfide (MoS₂) with a thickness of 20 nm was sputtered and deposited on the graphene material layer as a hole transport layer.

Sliver with a thickness of 200 nm was sputtered and deposited on the hole transport layer as a second electrode.

### Comparative Example 1

A ethylene terephthalate film was provided as a base material. The base material was placed in a magnetron sputtering chamber with argon gas and nitrogen gas introduced, and subjected to plasma cleaning for 30 min.

Indium tin oxide was sputtered on a surface of the base material as a first electrode.

Tin oxide (SnO₂) with a thickness of 20 nm was sputtered and deposited on the first electrode as an electron transport layer.

Methylammonium lead iodide with a thickness of 300 nm was sputtered on the electron transport layer as a perovskite layer.

Molybdenum disulfide (MoS₂) with a thickness of 20 nm was sputtered and deposited on the perovskite layer as a hole transport layer.

Sliver with a thickness of 200 nm was sputtered and deposited on the hole transport layer as a second electrode.

### Comparative Example 2

A ethylene terephthalate film was provided as a base material. The base material was placed in a magnetron sputtering chamber with argon gas and nitrogen gas introduced, and subjected to plasma cleaning for 30 min.

Indium tin oxide was sputtered on a surface of the base material as a first electrode.

Tin oxide (SnO₂) with a thickness of 20 nm was sputtered and deposited on the first electrode as an electron transport layer.

Methylammonium lead iodide with a thickness of 300 nm was sputtered on the electron transport layer as a perovskite layer.

Graphene with a thickness of 5 nm was sputtered on the perovskite layer as a graphene material layer, with graphite as a target, a sputtering power controlled to be 350 W, and a sputtering time of 5 min.

Molybdenum disulfide (MoS₂) with a thickness of 20 nm was sputtered and deposited on the graphene material layer as a hole transport layer.

Sliver with a thickness of 200 nm was sputtered and deposited on the hole transport layer as a second electrode.

### Comparative Example 3

A ethylene terephthalate film was provided as a base material. The base material was placed in a magnetron sputtering chamber with argon gas and nitrogen gas introduced, and subjected to plasma cleaning for 30 min.

Indium tin oxide was sputtered on a surface of the base material as a first electrode.

Tin oxide (SnO₂) with a thickness of 20 nm was sputtered and deposited on the first electrode as an electron transport layer.

Methylammonium lead iodide with a thickness of 300 nm was sputtered on the electron transport layer as a perovskite layer.

Hexagonal boron nitride with a thickness of 2 nm was sputtered on the perovskite layer as a boron nitride layer, with boron nitride as a target, a sputtering power controlled to be 250 W, and a sputtering time of 3 min.

Molybdenum disulfide (MoS₂) with a thickness of 20 nm was sputtered and deposited on the boron nitride layer as a hole transport layer.

Sliver with a thickness of 200 nm was sputtered and deposited on the hole transport layer as a second electrode.

Testing: The perovskite solar cells in above examples and comparative examples were each tested for an initial conversion efficiency and an operating time required for the conversion efficiency to decline to 90% of the initial conversion efficiency, indicated as T90 lifetime. The results are shown in Table 1.

**Table 1**

| | Initial conversion efficiency | T90 lifetime (h) |
|---|---|---|
| Example 1 | 14.55% | >1800 |
| Example 1 | 14.08% | >1500 |
| Comparative Example 1 | 7.45% | >400 |
| Comparative Example 2 | 6.58% | >500 |
| Comparative Example 3 | 7.62% | >400 |

As shown in Table 1, the initial conversion efficiencies of the solar cells prepared in Examples 1 and 2 can reach over 14%, and their T90 lifetimes can reach over 1500 hours. Such results are comparable to the conversion efficiency obtained in the conventional art where the hole transport layer is prepared by coating and the second electrode is prepared by evaporation. This indicates that the whole composite protective layer, which is formed by first preparing the boron nitride layer and then preparing the graphene material layer, can provide good protection for the perovskite layer with substantially no damage to the perovskite layer, enabling the perovskite solar cell to maintain a high initial conversion efficiency.

In contrast, Comparative Example 1, in which neither the boron nitride layer nor the graphene material layer is prepared, shows an initial conversion efficiency of only 7.45% and a significantly shorter T90 lifetime, which is primarily due to substantial damage to the perovskite layer caused by high-energy particles during the sputtering preparation of the hole transport layer and the second electrode. Comparative Example 2, in which only the graphene material layer is prepared, instead shows a lower initial conversion efficiency than Comparative Example 1, primarily due to significant damage to the perovskite layer during sputtering the graphene material layer; however, it has a slightly longer T90 lifetime, which is mainly attributed to the blocking effect of the graphene material layer. Comparative Example 3, in which only the boron nitride layer is prepared, shows a similar initial conversion efficiency as Comparative Example 1 and a substantially identical T90 lifetime to Comparative Example 1, suggesting that the boron nitride layer alone cannot protect the perovskite layer from damage caused by high-energy particles generated during the subsequent sputtering process.

The preparation method as described in Examples 1 and 2 employs sputtering to sequentially prepare the perovskite layer, the composite protective layer, the second charge extraction layer, and the second electrode, enabling a sequential preparation on a single sputtering production line, without requiring drying or annealing treatments, which offers advantages of a lower cost, a lower energy consumption, and a shorter production time, making it a highly desirable solar cell manufacturing approach.

It should be noted that the above embodiments are for descriptive purposes only and are not intended to limit the present application.

It should be understood that, unless otherwise explicitly stated herein, there are no strict restrictions on the performing orders of the steps, and the steps can be performed in other orders. Moreover, at least some of the steps may include multiple sub-steps or stages. The multiple sub-steps or stages may not necessarily be completed at the same time, but may be completed at different times. The multiple sub-steps or stages may not necessarily be performed sequentially but performed alternately or by turns with at least part of other steps or sub-steps or stages of other steps.

The embodiments in this specification are all described in a progressive manner. Each embodiment focuses on the difference from the other embodiments, and for same or similar parts in the embodiments, reference may be made to these embodiments.

The technical features of the above embodiments may be combined arbitrarily. In order to make the description concise, not all possible combinations of the technical features in the above embodiments are described. However, as long as there is no contradiction in the combination of these technical features, the combinations should be considered as in the scope of this specification.

## Claims

1. A perovskite solar cell, comprising a substrate, a first charge extraction layer, a perovskite layer, a composite protective layer, and a second charge extraction layer, wherein the first charge extraction layer, the perovskite layer, the composite protective layer, and the second charge extraction layer are sequentially stacked on the substrate, and the composite protective layer comprises a boron nitride layer and a graphene material layer sequentially stacked on the perovskite layer.

2. The perovskite solar cell according to claim 1, wherein a thickness of the boron nitride layer is ≤10 nm.

3. The perovskite solar cell according to any one of claims 1 to 2, wherein a thickness of the graphene material layer is ≤10 nm.

4. The perovskite solar cell according to any one of claims 1 to 3, wherein the boron nitride layer is in direct contact with the perovskite layer, and the graphene material layer is in direct contact with the boron nitride layer.

5. The perovskite solar cell according to any one of claims 1 to 4, wherein the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

6. The perovskite solar cell according to any one of claims 1 to 5, wherein the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.

7. A method for preparing a perovskite solar cell, comprising the following steps:
providing a substrate;
preparing a first charge extraction layer on the substrate;
preparing a perovskite layer on the first charge extraction layer;
sequentially preparing a boron nitride layer and a graphene material layer on the perovskite layer to form a composite protective layer; and
preparing a second charge extraction layer on the graphene material layer.

8. The method for preparing the perovskite solar cell according to claim 7, wherein a thickness of the boron nitride layer is ≤10 nm.

9. The method for preparing the perovskite solar cell according to any one of claims 7 to 8, wherein a thickness of the graphene material layer is ≤10 nm.

10. The method for preparing the perovskite solar cell according to any one of claims 7 to 9, wherein the boron nitride layer is in direct contact with the perovskite layer, and the graphene material layer is in direct contact with the boron nitride layer.

11. The method for preparing the perovskite solar cell according to any one of claims 7 to 10, wherein the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

12. The method for preparing the perovskite solar cell according to any one of claims 7 to 11, wherein the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.

13. The method for preparing the perovskite solar cell according to any one of claims 7 to 12, wherein the boron nitride layer is prepared by sputtering, and the graphene material layer is prepared by sputtering.

14. The method for preparing the perovskite solar cell according to any one of claims 7 to 13, wherein in the step of preparing the boron nitride layer, hexagonal boron nitride is used as a sputtering target, a sputtering power is controlled in a range from 200 W to 350 W, and a sputtering time period is controlled in a range from 1 min to 10 min.

15. The method for preparing the perovskite solar cell according to any one of claims 7 to 14, wherein in the step of preparing the graphene material layer, graphite is used as a sputtering target, a sputtering power is controlled in a range from 300 W to 400 W, and a sputtering time period is controlled in a range from 1 min to 10 min.

16. The method for preparing the perovskite solar cell according to any one of claims 7 to 15, wherein the first charge extraction layer, the perovskite layer, the boron nitride layer, the graphene material layer, and the second charge extraction layer are sequentially prepared by sputtering in a sputtering chamber.

17. The method for preparing the perovskite solar cell according to any one of claims 7 to 16, wherein the substrate comprises a base material and a first electrode disposed on the base material, and before preparing the first charge extraction layer, the method further comprises a step of subjecting the base material to plasma cleaning.

18. The method for preparing the perovskite solar cell according to any one of claims 7 to 17, after preparing the second charge extraction layer, further comprising a step of preparing a second electrode on the second charge extraction layer, wherein the second electrode is prepared by sputtering.

19. A photovoltaic module, comprising an encapsulation structure and a perovskite solar cell encapsulated by the encapsulation structure, wherein the perovskite solar cell comprises a substrate, a first charge extraction layer, a perovskite layer, a composite protective layer, and a second charge extraction layer; the first charge extraction layer, the perovskite layer, the composite protective layer, and the second charge extraction layer are sequentially stacked on the substrate; and the composite protective layer comprises a boron nitride layer and a graphene material layer sequentially stacked on the perovskite layer.

20. The photovoltaic module according to claim 19, wherein a thickness of the boron nitride layer is ≤10 nm.

21. The photovoltaic module according to any one of claims 19 to 20, wherein a thickness of the graphene material layer is ≤10 nm.

22. The photovoltaic module according to any one of claims 19 to 21, wherein the boron nitride layer is in direct contact with the perovskite layer, and the graphene material layer is in direct contact with the boron nitride layer.

23. The photovoltaic module according to any one of claims 19 to 22, wherein the first charge extraction layer is an electron transport layer, and a material of the first charge extraction layer is one or more selected from the group consisting of fullerene, tin oxide, tungsten sulfide, zinc oxide, titanium oxide, tungsten oxide, and indium gallium zinc oxide.

24. The photovoltaic module according to any one of claims 19 to 23, wherein the second charge extraction layer is a hole transport layer, and a material of the second charge extraction layer is one or more selected from the group consisting of nickel oxide, copper oxide, copper sulfide, molybdenum sulfide, vanadium oxide, tungsten oxide, and copper thiocyanate.
